(19) Europäisches Patentamt
European Patent Office
Office européen des brevets

(11) **EP 4 287 350 A1**

(12) **EUROPEAN PATENT APPLICATION**
published in accordance with Art. 153(4) EPC

(43) Date of publication:
**06.12.2023 Bulletin 2023/49**

(21) Application number: **21965984.4**

(22) Date of filing: **01.12.2021**

(51) International Patent Classification (IPC):
**H01M 10/44** $^{(2006.01)}$

(52) Cooperative Patent Classification (CPC):
**H01M 10/44**

(86) International application number:
**PCT/CN2021/134746**

(87) International publication number:
**WO 2023/097547 (08.06.2023 Gazette 2023/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Contemporary Amperex Technology Co., Limited**
**Ningde, Fujian 352100 (CN)**

(72) Inventors:
• **CHEN, Xinwei**
**Ningde, Fujian 352100 (CN)**

• **DAN, Zhimin**
**Ningde, Fujian 352100 (CN)**
• **YAN, Yu**
**Ningde, Fujian 352100 (CN)**
• **ZHAO, Yuanmiao**
**Ningde, Fujian 352100 (CN)**
• **LI, Zhanliang**
**Ningde, Fujian 352100 (CN)**
• **HOU, Yizhen**
**Ningde, Fujian 352100 (CN)**

(74) Representative: **Rowlands, Stuart Michael**
**Maucher Jenkins**
**Seventh Floor Offices**
**Artillery House**
**11-19 Artillery Row**
**London SW1P 1RT (GB)**

(54) **BATTERY HEATING METHOD AND APPARATUS, AND DEVICE AND STORAGE MEDIUM**

(57)    Provided in the embodiments of the present application are a battery heating method and apparatus, and a device and a storage medium. The battery heating method comprises: acquiring a first temperature and a first state of charge of a battery; determining a first current frequency according to the first temperature, the first state of charge and a preset first data table, wherein the first data table comprises, under the condition of a first current amplitude, correspondences between the first temperature, the first state of charge and the first current frequency; and heating the battery on the basis of the first current amplitude and the first current frequency. In the embodiments of the present application, a current frequency and amplitude for internal heating can be determined according to the temperature of a battery, thereby improving the battery heating rate in various types of temperature environments.

```
┌─────────────────────────────────────────────────┐
│ acquiring a first temperature and a first state  │── 501
│ of charge of a battery                           │
└─────────────────────────────────────────────────┘
                      │
                      ▼
┌─────────────────────────────────────────────────┐
│ determining a first current frequency based on   │
│ the first temperature, the first state of charge,│
│ and preset first data tables, the first data     │── 502
│ tables including correspondence between the first│
│ temperature, the first state of charge, and the  │
│ first current frequency under a condition of a   │
│ first current amplitude                          │
└─────────────────────────────────────────────────┘
                      │
                      ▼
┌─────────────────────────────────────────────────┐
│ heating the battery based on the first current   │── 503
│ amplitude and the first current frequency        │
└─────────────────────────────────────────────────┘
```

FIG. 5

## Description

### TECHNICAL FIELD

The present disclosure relates to the technical field of battery, and in particular, to a battery heating method, apparatus, device and storage medium.

### BACKGROUND

As is well known, temperature has a significant impact on working performance of batteries. When in a low-temperature working environment, Batteries such as lithium batteries and the like are usually heated to a high temperature to improve their performance.

In related technologies, batteries are usually heated based on fixed heating parameters, which results in a low heating rate.

### SUMMARY

The disclosure provides a battery heating method, apparatus, device, and storage medium to solve the problem of low battery heating rate in related technologies.

In a first aspect, the disclosure provides a battery heating method, comprising:

acquiring a first temperature and a first state of charge of a battery;
determining a first current frequency based on the first temperature, the first state of charge, and one or more preset first data tables, the first data tables including correspondence between the first temperature, the first state of charge, and the first current frequency under a condition of a first current amplitude;
heating the battery based on the first current amplitude and the first current frequency.

With the battery heating method provided in the embodiments of the disclosure, the first temperature and the first state of charge of the battery are acquired, the first current frequency is determined based on the first temperature, the first state of charge, and the preset first data tables, and the battery is heated based on the first current amplitude and the first current frequency. The first data tables include correspondence between the first temperature, the first state of charge, and the first current frequency under the condition of the first current amplitude. With the embodiments of the disclosure, the current frequency and amplitude used for internal heating can be determined based on the temperature of the battery, so that the heating rate of the battery at various temperature environments is improved. Since the first current amplitude is predetermined, the consumption of computing resources caused by determination of the first current amplitude can be saved in determination of the battery's heating parameters, so that the efficiency of determination of the battery's heating parameters can be improved. Moreover, there is no need to establish the above first data tables for various current amplitudes, which helps to reduce the human and material consumption caused by establishment of the first data tables. By determining the first current amplitude, the situation that the current amplitude actually used for heating the battery is too high due to the lack of the limit of the current amplitude used for heating the battery, resulting in lithium precipitation of the cell, can be avoided.

In some embodiments, a number of the first data tables is N, the N first data tables are associated with N states of health of the battery, and N is an integer greater than 1;

the determining a first current frequency based on the first temperature, the first state of charge, and one or more preset first data tables comprises:

acquiring a first state of health of the battery;
determining a second data table associated with the first state of health from the N first data tables;
determining the first current frequency based on the first temperature, the first state of charge, and the second data table.

With the embodiments, the state of health (SOH) is considered as safety redundancy, which further improves the reliability of the battery heating process.

In some embodiments, the heating the battery based on the first current amplitude and the first current frequency comprises:

heating, starting from a first time instance, the battery based on the first current amplitude and the first current frequency;

after the heating the battery based on the first current amplitude and the first current frequency, the method further comprises:

returning, under a condition that a second time instance is reached, to perform the acquiring a first temperature and a first state of charge of a battery, a period between the second time instance and the first time instance being equal to a first preset period.

With the embodiments, the battery is heated in different heating cycles. During each heating cycle, the current frequency used for heating the battery is adjusted according to the first temperature of the battery, which helps to effectively improve the heating safety and efficiency of the battery.

In some embodiments, after the determining a first current frequency based on the first temperature, the first state of charge, and one or more preset first data tables, the method further comprises:

determining, under a condition that a second current amplitude is acquired, a third current frequency based on the second current amplitude, the third current frequency being a safe current frequency for heating the battery under a condition of the second current amplitude;
heating the battery based on the second current amplitude and a larger one of the first current frequency and the third current frequency.

With the embodiments, the safety of the battery heating process can be effectively guaranteed under various current amplitude conditions.

In a second aspect, the present disclosure provides a battery heating method, comprising:

acquiring a second temperature and a second state of charge of a battery;
determining a third current amplitude based on the second temperature, the second state of charge, and one or more preset third data tables, the third data tables including correspondence between the second temperature, the second state of charge, and the third current amplitude under a condition of a fourth current frequency;
heating the battery based on the fourth current frequency and the third current amplitude.

With the battery heating method provided in the embodiments of the disclosure, the second temperature and the second state of charge of the battery are acquired, the third current amplitude is determined based on the second temperature, the second state of charge, and the preset third data tables, and the battery is heated based on the fourth current frequency and the third current amplitude. The third data tables include correspondence between the second temperature, the second state of charge, and the third current amplitude under the condition of the fourth current frequency. With the embodiments of the disclosure, the current frequency and amplitude used for internal heating can be determined based on the temperature of the battery, so that the heating rate of the battery at various temperature environments is improved. Since the fourth current frequency is predetermined, the consumption of computing resources caused by determination of the fourth current frequency can be saved in determination of the battery's heating parameters, so that the efficiency of determination of the battery's heating parameters can be improved. Moreover, there is no need to establish the above third data tables for various current amplitudes, which helps to reduce the human and material consumption caused by establishment of the third data tables. By determining the first current frequency, the situation that the current frequency actually used for heating the battery is too high due to the lack of the limit of the current frequency used for heating the battery can be avoided.

In some embodiments, after the determining a third current amplitude, the method further comprises:

acquiring an output voltage of the battery;
heating, under a condition that the output voltage is less than a voltage threshold, the battery based on a preset fifth current frequency and the third current amplitude;
the heating the battery based on the fourth current frequency and the third current amplitude comprises:

heating the battery based on the fourth current frequency and the third current amplitude under a condition that the output voltage is greater than or equal to the voltage threshold;
wherein the fifth current frequency is greater than the fourth current frequency.

With the embodiments, both safety and efficiency of the battery heating process are considered.

In some embodiments, the third current amplitude is a forward current amplitude;
the heating the battery based on the fourth current frequency and the third current amplitude comprises:
heating the battery based on the fourth current frequency, the third current amplitude, and a preset first negative current amplitude.

The embodiments assist with reducing the computation involved in determining the heating parameters and also ensure the safety of the battery heating process.

In some embodiments, after the determining a third current amplitude, the method further comprises:

acquiring an output voltage of the battery;

heating, under a condition that the output voltage is less than a voltage threshold, the battery based on the fourth current frequency, the third current amplitude, and a preset second negative current amplitude;

the heating the battery based on the fourth current frequency, the third current amplitude, and a preset first negative current amplitude comprises:

heating, under a condition that the output voltage is greater than or equal to the voltage threshold, the battery based on the fourth current frequency, the third current amplitude, and the preset first negative current amplitude;

wherein the first negative current amplitude is greater than the second negative current amplitude.

The embodiments assist in avoiding safety problems caused by excessive battery discharge and in turn improve battery life.

In some embodiments, a number of the third data tables is M, the M third data tables are associated with M states of health of the battery, and M is an integer greater than 1;

the determining a third current amplitude based on the second temperature, the second state of charge, and one or more preset third data tables comprises:

acquiring a second state of health of the battery;

determining a fourth data table associated with the second state of health from the M third data tables;

determining the third current amplitude based on the second temperature, the second state of charge, and the fourth data table.

With the embodiments, the SOH is considered as safety redundancy, which further improves the reliability of the battery heating process.

In some embodiments, the heating the battery based on the fourth current frequency and the third current amplitude comprises:

heating, starting from a third time instance, the battery based on the fourth current frequency and the third current amplitude;

after the heating the battery based on the fourth current frequency and the third current amplitude, the method further comprises:

returning, under a condition that a fourth time instance is reached, to perform the acquiring a second temperature and a second state of charge of a battery, a period between the fourth time instance and the third time instance being equal to a second preset period.

With the embodiments, the battery is heated in different heating cycles. During each heating cycle, the current amplitude used for heating the battery is adjusted according to the second temperature of the battery, which helps to effectively improve the heating safety and efficiency of the battery.

In a third aspect, the present disclosure provides a battery heating apparatus, comprising:

a first acquisition module, configured to acquire a first temperature and a first state of charge of a battery;

a first determination module, configured to determine a first current frequency based on the first temperature, the first state of charge, and one or more preset first data tables, the first data tables including correspondence between the first temperature, the first state of charge, and the first current frequency under a condition of a first current amplitude;

a first heating control module, configured to heat the battery based on the first current amplitude and the first current frequency.

In a fourth aspect, the present disclosure provides a battery heating apparatus, comprising:

a second acquisition module, configured to acquire a second temperature and a second state of charge of a battery;

a second determination module, configured to determine a third current amplitude based on the second temperature, the second state of charge, and one or more preset third data tables, the third data tables including correspondence between the second temperature, the second state of charge, and the third current amplitude under a condition of a fourth current frequency;
a second heating control module, configured to heat the battery based on the fourth current frequency and the third current amplitude.

In a fifth aspect, the present disclosure provides an electronic device, comprising a processor, and a memory storing computer program instructions;
the processor executes the computer program instructions to implement the battery heating method according to the first aspect, or implement the battery heating method according to the second aspect.

In a sixth aspect, the present disclosure provides a computer storage medium storing computer program instructions thereon, which, when executed by a processor, implement the battery heating method according to the first aspect or implement the battery heating method according to the second aspect.

## BRIEF DESCRIPTION OF THE DRAWINGS

In order to more clearly illustrate technical solutions of the embodiments of the present disclosure, drawings used in the embodiments of the present disclosure will be briefly described below. Obviously, the attached drawings described below are only some embodiments of this application. For those skilled in the art, other drawings may be obtained from these figures without any creative work.

Figure 1 is a schematic diagram of an equivalent circuit of a lithium-ion battery;
Figure 2 is a schematic diagram of the maximum amplitude-frequency relationship of alternating current in a lithium-ion battery at different temperatures under a condition of inhibiting lithium precipitation;
Figure 3 is a schematic diagram of the maximum heat generation power preheated with different temperatures and different alternating current frequencies under a condition of inhibiting lithium precipitation;
Figure 4 is a schematic diagram of selecting the optimal frequency point for a given alternating current amplitude;
Figure 5 is a flowchart of a battery heating method disclosed in an embodiment of the present disclosure;
Figure 6 is an example diagram of a battery heating process;
Figure 7 is a flowchart of a battery heating method disclosed in another embodiment of the present disclosure;
Figure 8 is another example diagram of a battery heating process;
Figure 9 is a structural schematic diagram of a heating system for heating a battery;
Figure 10 is another structural schematic diagram of a heating system for heating a battery;
Figure 11 is a structural schematic diagram of a battery heating apparatus disclosed in an embodiment of the present disclosure;
Figure 12 is a structural schematic diagram of a battery heating apparatus disclosed in another embodiment of the present disclosure;
Figure 13 illustrates a structural schematic diagram of an electronic device disclosed in an embodiment of the present disclosure.

## DETAILED DESCRIPTION

The following will provide a further detailed description of the embodiments of the present disclosure in conjunction with the accompanying drawings and embodiments. The detailed description of the following embodiments and accompanying drawings are used to exemplify the principles of the present disclosure, but cannot be used to limit the scope of the present disclosure, that is, the present disclosure is not limited to the described embodiments.

It should be noted that, in this context, relationship terms such as "first" and "second" are used merely to distinguish one entity or operation from another entity or operation, and do not necessarily require or imply that there is any such an actual relationship or order between such entities or operations. Furthermore, the term "comprise" or "include" or any other variations thereof is intended to encompass a non-exclusive inclusion, such that a process, method, article, or device that comprises a plurality of elements includes not only those elements but also other elements that are not listed exactly, or elements that are inherent to such a process, method, article, or device. An element that is defined by the phrase "comprising", without more limitation, does not exclude the presence of additional elements in the process, method, article, or device.

Generally, for batteries such as lithium-ion batteries and the like, the working environment has a significant impact on their performance. Taking a lithium-ion battery in an electric vehicle as an example, when the electric vehicle is started in a low-temperature environment, the performance of the lithium-ion battery may decrease at the low temperature, which may cause the electric vehicle to fail to start or drive normally.

Of course, in practical applications, not only lithium batteries, but also other types of batteries, such as sodium ion batteries or magnesium ion batteries, may have a need for heating.

Currently, there are two main methods for heating batteries: external heating and internal heating. The external heating is mainly achieved through thermal conduction or convection, using PTC materials or heating films to heat the battery externally. However, this method is prone to uneven heating and low heating efficiency. Internal heating leads to higher energy efficiency and more uniform heating due to direct generation of heat inside the battery.

During research process, the inventor compared various heating methods and found that with internal heating through alternating current (hereinafter referred to as alternating current internal heating), the temperature uniformity of the battery was good, and the energy loss of the battery was small.

When the power source for heating is the battery itself, internal heating of the battery through direct current (hereinafter referred to as direct current internal heating) can avoid introducing circuit components that achieve functions such as inversion, which has a lower cost but causes significant energy loss to the battery. Moreover, excessive direct current may have a certain impact on the battery life.

Overall, compared to external heating and direct current internal heating, alternating current internal heating is easier to implement, and the battery heating speed is faster and the heating uniformity is better.

For simplification, the following will mainly use lithium batteries as an example for explanation.

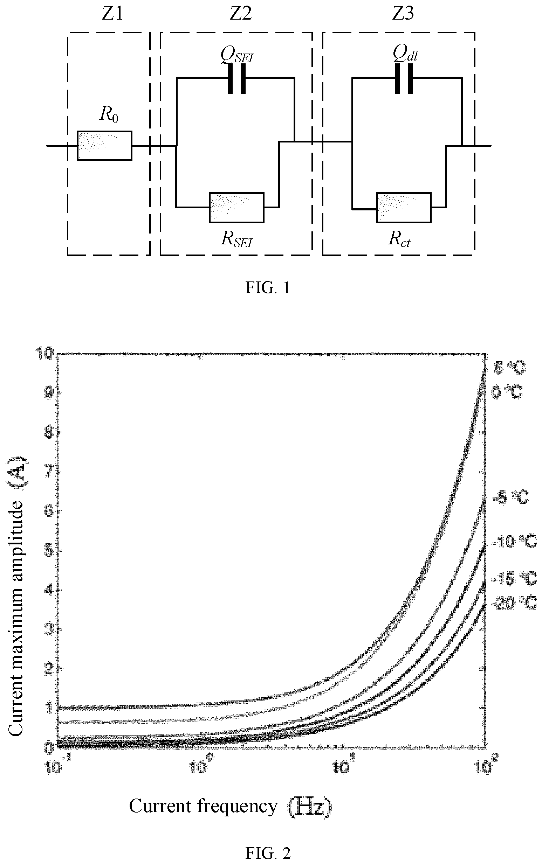

As shown in Figure 1, which is a schematic diagram of an equivalent circuit of a lithium-ion battery. Based on this equivalent circuit, as shown, the impedance of the lithium-ion battery is mainly composed of three parts: Z1, Z2, and Z3.

Z1 is an ohmic impedance component $R_0$ of the current collector, active material, and electrolyte in the lithium-ion battery. Z2 is an impedance component corresponding to a solid electrolyte interphase (SEI) film on the particle surface, including a capacitance impedance $Q_{SEI}$ and an ohmic impedance $R_{SEI}$. Z3 includes a double layer capacitance Qai at a solid-liquid phase interface of active substance, a charge transfer impedance $R_{ct}$, and an impedance W corresponding to diffusion process of lithium ions.

Generally, when current flows through the battery, it may cause the battery potential to deviate from the equilibrium potential, which can be referred to as battery polarization.

When the lithium battery undergoes polarization, lithium precipitation may be caused at the negative electrode. Specifically, during the charging process of the lithium-ion battery, lithium ions will detach from the positive electrode and embed into the negative electrode. However, when some abnormal conditions occur and lithium ions that are detached from the positive electrode fail to embed into the negative electrode, the lithium ions can only precipitate on the surface of the negative electrode, forming a layer of gray material.

Lithium precipitation not only reduces battery performance and significantly shortens cycle life, but also limits the fast charging capacity of the battery and may cause catastrophic consequences such as combustion and explosion.

To avoid lithium precipitation from the negative electrode, it is necessary to meet the requirement that the solid-liquid phase potential difference on the particle surface of the negative electrode is greater than the equilibrium potential of the lithium precipitation reaction, namely:

$$\Phi_s - \Phi_l > U_{e,2}$$

where $\Phi_s$ is the solid phase potential of the particle surface of the negative electrode, $\Phi_l$ is the liquid phase potential of the particle surface of the negative electrode, and $U_{e,2}$ is the equilibrium potential of the lithium precipitation reaction, usually considered as 0V.

When lithium precipitation reaction occurs, lithium ions need to obtain electrons to reduce to lithium metal. It is generally believed that the lithium precipitation reaction initially occurs inside the SEI film on the surface of graphite particles, where the lithium intercalation reaction has an overpotential $\eta$:

$$\eta = \Phi_s - \Phi_l - U_{e,1}$$

where $U_{e,1}$ is the equilibrium potential of the graphite negative electrode under a specific state of charge (SOC).

According to derivation process of impedance spectrum of the lithium-ion battery, with linearization of the Butler-Volmer equation, the overpotential of the lithium embedding reaction may be approximated as:

$$\eta \approx I_{ct} R_{ct}$$

In the formula, $I_{ct}$ is Faraday current, $R_{ct}$ is charge transfer impedance, and the symbol of $I_{ct}$ is negative during charging.

The equivalent circuit corresponding to the graphite negative electrode has the following relationship:

$$I_{ct}R_{ct} = -V_3$$

where $V_3$ is the voltage across the charge transfer impedance $R_{ct}$, that is the voltage across the impedance Z3 in the equivalent circuit shown in Figure 1.

According to the above formula, in order to avoid lithium precipitation on the negative electrode surface, it is necessary to meet the following requirement:

$$V_3 < U_{e,1} \qquad\qquad (1)$$

The impedance value of the impedance Z3 in the equivalent circuit is related to current frequency, which is expressed as:

$$Z_3 = \frac{R_{ct}}{(j\omega)^{n_{dl}}Q_{dl}R_{ct}+1} \qquad\qquad (2)$$

where $Z_3$ is the impedance value of the impedance Z3, $j$ is the imaginary unit, $\omega$ is the current frequency, $n_{dl}$ is the constant phase angle element (CPE) index of the impedance Z3, and $Q_{dl}$ is the CPE coefficient of the impedance Z3.

When alternating current excitation is applied to the lithium-ion battery, the voltage amplitude across Z3 is:

$$|V_3| = I_{ac}|Z_3| \qquad\qquad (3)$$

In the formula, $|V3|$ is the impedance amplitude of the impedance Z3, which is related to the current frequency; $I_{ac}$ is the amplitude of the applied alternating current.

From formulas (1) and (3), the condition for the lithium ion battery not to undergo lithium precipitation under alternating current excitation is:

$$I_{ac}|Z_3| < U_{e,1} \qquad\qquad (4)$$

That is, in the equivalent circuit of the graphite negative electrode of the lithium-ion battery, the voltage amplitude across the impedance Z3 (the voltage amplitude across the charge transfer impedance $R_{ct}$) is always smaller than the equilibrium potential of the graphite negative electrode.

Generally, as the temperature decreases, the real and imaginary parts of the impedance of the positive and negative electrodes significantly increase; the real part of the impedance of the positive and negative electrodes decreases with increasing frequency.

From formulas (2) and (4), the maximum amplitude that can be applied to alternating current heating current at different frequencies at different temperatures under the condition of suppressing lithium precipitation can be calculated by the fitted equivalent circuit parameters of the negative electrode. This is the maximum amplitude-frequency relationship of alternating current of the lithium-ion battery at different temperatures, which can be seen in Figure 2.

As the impedance amplitude of Z3 of the graphite negative electrode equivalent circuit decreases with increasing temperature and frequency, the maximum allowable alternating current amplitude increases with increasing frequency or temperature.

As shown above, the maximum allowable current increases with increasing frequency, and the real part of the battery impedance increases with decreasing frequency. According to the heat generation power $P = I^2 R$, it is necessary to find a balance between frequency and current to maximize the heating power. Among them, P is the heat generation power, I is the current, and R is the resistance.

Specifically, in the equivalent circuit of the lithium-ion battery shown in Figure 1, as the frequency increases, the current component through $R_{ct}$ and $R_{SEI}$ decreases, and the heat generation power will come more from the heat generation on the ohmic internal resistance $R_0$.

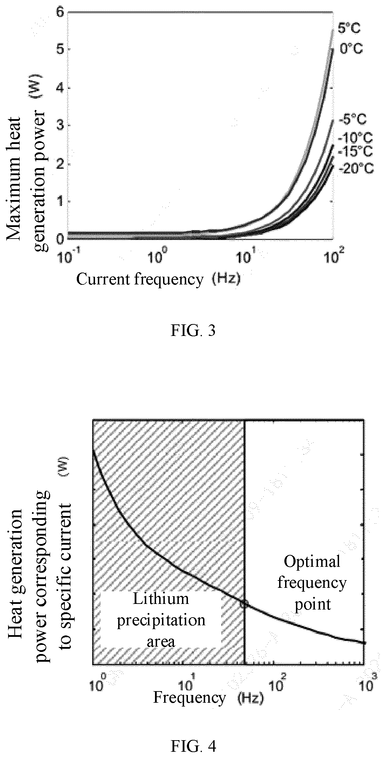

As shown in Figure 3, it is a schematic diagram of the maximum heat generation power preheated with different temperatures and different alternating current frequencies under a condition of inhibiting lithium precipitation. In an ideal situation, the current passing through $R_{ct}$ is reduced by increasing the frequency, and the voltage is reduced to avoid lithium precipitation, and meanwhile the total current is caused to be greater to generate greater heat through $R_0$.

In the actual process, there is also a limitation on the maximum current amplitude of the heating device (either built-in or external). When the maximum current amplitude is given, if the current frequency is too low, lithium precipitation will occur; and if the current frequency is too high, the heat generation power is small. Therefore, in this case, there is an optimal value for the frequency.

As shown in Figure 4, it is a schematic diagram of selecting the optimal frequency point for a given alternating current amplitude. Based on Figure 4, it can be seen that at the boundary of the shaded area, the maximum heat generation power of the battery without lithium precipitation can be obtained, which is the optimal frequency point. By selecting the appropriate current amplitude and frequency, the heating efficiency can be maximized.

However, in related technologies, the current amplitude and frequency used for internal heating of the lithium battery is usually determined based on the designed lowest temperature of the lithium battery. In subsequent applications, this current amplitude and frequency are used to heat the lithium battery, making it difficult to achieve efficient heating of the lithium battery in various environments.

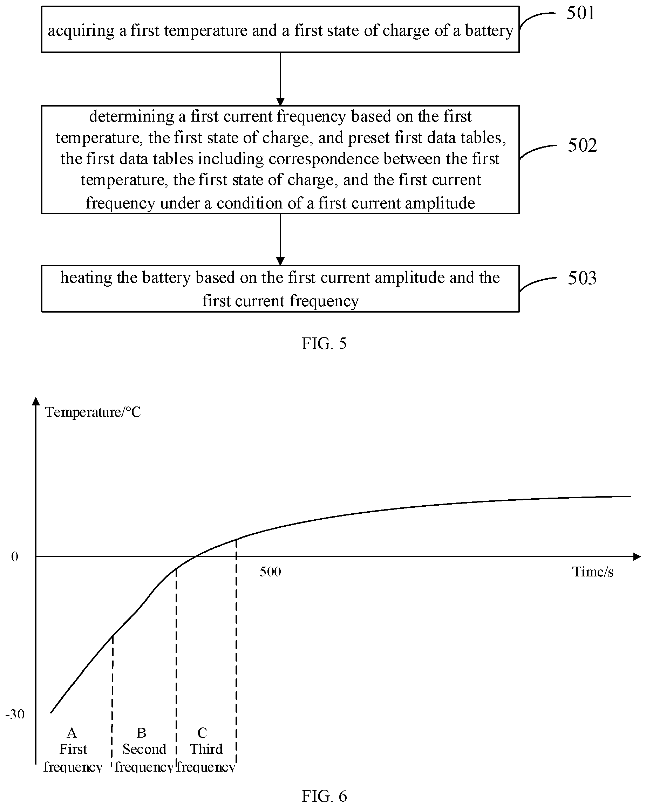

According to some embodiments of the present disclosure, in order to solve the problems existing in related technologies, a battery heating method is provided, as shown in Figure 5. The method includes:

Step 501, acquiring a first temperature and a first state of charge of a battery;

Step 502, determining a first current frequency based on the first temperature, the first state of charge, and one or more preset first data tables, the first data tables including correspondence between the first temperature, the first state of charge, and the first current frequency under a condition of a first current amplitude;

Step 503, heating the battery based on the first current amplitude and the first current frequency.

In the embodiments, the battery may be a lithium-ion battery, a lithium-sulfur battery, a sodium ion battery, or a magnesium ion battery, etc., which is not limited here. For simplification, the following will mainly take a lithium-ion battery as an example for description.

The first temperature of the battery may refer to a battery temperature collected in real-time, which may be collected through a relevant temperature sensing device. The first temperature may be the temperature inside a battery pack where the battery is located or the temperature of the working environment where the battery is located.

The first state of charge may be the real-time SOC of the battery, which may be collected through a battery SOC signal acquisition device.

In some application scenarios, the first temperature and first state of charge may be collected through a battery management system (BMS), etc.

The first data tables may be pre-established. During establishing of the first data tables, the current amplitude may be controlled, the battery temperature and SOC may be changed, and the electrochemical impedance spectroscopy (EIS) data of the battery under each combination of battery temperature and battery SOC may be acquired. Based on the EIS data, the current frequency under any combination of battery temperature and battery SOC may be determined. Generally, this current frequency may ensure that under the corresponding combination of battery temperature and battery SOC, the battery will not exhibit polarization phenomenon, and meanwhile be heated internally with a higher heating power.

In other words, when establishing the first data tables, the current amplitude may be taken as a fixed value, the battery temperature and battery SOC may be taken as independent variables, and the current frequency may be measured as the dependent variable.

The current amplitude in the first data tables is specifically controlled at the first current amplitude.

In some examples, the first current amplitude may be determined based on the rated current or maximum allowable current of a discharge device. For example, when the battery is used in an electric vehicle, the discharge device may be a motor controller, a charging station, or other energy storage unit, etc., and the first current amplitude may be equal to or slightly less than the maximum allowable current of the discharge device.

The first data tables may include the correspondence between the first temperature, the first state of charge, and first current frequency under the condition of the first current amplitude. After acquiring the first temperature and the first state of charge, the first current frequency may be determined through the first data tables.

Under a condition that the first current frequency is determined, the battery may be heated based on the first current amplitude and the first current frequency.

The first current amplitude and the first current frequency may be target heating parameters or reference heating parameters. For example, in practical applications, the battery may be heated with the first current amplitude and the first current frequency, or with the first current frequency and a current amplitude lower than the first current amplitude.

With the battery heating method provided in the embodiments of the disclosure, the first temperature and the first state of charge of the battery are acquired, the first current frequency is determined based on the first temperature, the first state of charge, and the preset first data tables, and the battery is heated based on the first current amplitude and the first current frequency. The first data tables include correspondence between the first temperature, the first state of charge, and the first current frequency under the condition of the first current amplitude. With the embodiments of the disclosure, the current frequency and amplitude used for internal heating can be determined based on the temperature of the battery, so that the heating rate of the battery at various temperature environments is improved.

Secondly, in the embodiments of the disclosure, since the first current amplitude is predetermined, the consumption of computing resources caused by determination of the first current amplitude can be saved in determination of the battery's heating parameters, so that the efficiency of determination of the battery's heating parameters can be improved. Moreover, there is no need to establish the above first data tables for various current amplitudes, which helps to reduce the human and material consumption caused by establishment of the first data tables.

In addition, by determining the first current amplitude, the situation that the current amplitude actually used for heating the battery is too high due to the lack of the limit of the current amplitude used for heating the battery, resulting in lithium precipitation of the cell, can be avoided.

Meanwhile, in the embodiments of the disclosure, the first data tables are established under the condition of the first current amplitude, and there is no need to establish correspondence between the battery temperature, the battery SOC, and the current frequency for multiple current amplitudes, which also helps to reduce the human and material resources required for establishing the correspondence.

In some examples, when establishing the first data tables, the first current amplitude may be determined first. Taking the battery in the electric vehicle as an example, the selection of the first current amplitude is related to the maximum overcurrent capacity of the heating system. If self-discharge is carried out through a motor controller of the electric vehicle, the first current amplitude is generally the maximum overcurrent of the motor controller. If heating is carried out through a quick heating charging pile, the first current amplitude is generally selected as the maximum overcurrent capacity of the charging pile. Overall, the first current amplitude refers to the maximum current amplitude that can be achieved under quick heating conditions without causing any safety risks to the heating system. The first current amplitude is generally determined at the beginning of system design.

In an example, the first current amplitude may be 300A and the safe current frequency of the battery can be calibrated separately with SOC of 0%~100% and temperature of - 30 °~10 °. The safe current frequency may be determined based on formulas (2) and (4).

When acquiring the current frequency with highest heating efficiency (i.e. the optimal frequency point) through calibration testing of the battery, the optimal frequency point acquired should not be lower than the corresponding safe current frequency.

Based on the calibration testing, a first data table may be obtained. The following is an example of the first data table.

| Optimal frequency point with 300A alternating current | | | | | | | | | | | | | |
|---|---|---|---|---|---|---|---|---|---|---|---|---|---|
| SOC | | 0% | 10% | 20% | 30% | 40% | 50% | 60% | 70% | 80% | 85% | 90% | 95% | >95% |
| Temperature 1 | -30 | XHz | XHz | XHz | XHz | XHz | XHz | XHz | XHz | XHz | XHz | XHz | XHz | |
| Temperature 2 | -25 | XHz | XHz | XHz | XHz | XHz | XHz | XHz | XHz | XHz | XHz | XHz | XHz | |
| Temperature 3 | -20 | XHz | XHz | XHz | XHz | XHz | XHz | XHz | XHz | XHz | XHz | XHz | XHz | |
| Temperature 4 | -15 | XHz | XHz | XHz | XHz | XHz | XHz | XHz | XHz | XHz | XHz | XHz | XHz | |
| Temperature 5 | -10 | XHz | XHz | XHz | XHz | XHz | XHz | XHz | XHz | XHz | XHz | XHz | XHz | |
| Temperature 6 | -5 | XHz | XHz | XHz | XHz | XHz | XHz | XHz | XHz | XHz | XHz | XHz | XHz | |
| Temperature 7 | 0 | XHz | XHz | XHz | XHz | XHz | XHz | XHz | XHz | XHz | XHz | XHz | XHz | |
| Temperature 8 | 5 | XHz | XHz | XHz | XHz | XHz | XHz | XHz | XHz | XHz | XHz | XHz | XHz | |
| Temperature 9 | 10 | XHz | XHz | XHz | XHz | XHz | XHz | XHz | XHz | XHz | XHz | XHz | XHz | |

It is worth noting that the various data in the first data table above are provided as exemplary description. For example, "XHz" represents a frequency value, and the specific value represented by "X" in each table can be acquired through calibration testing, rather than specifically referring to a certain value. That is to say, the value of "X" in different tables can be the same or different. In addition, in practical applications, the first current amplitude, the calibrated range of SOC, and the calibrated range of temperature all can be adjusted as needed.

According to some embodiments of the present disclosure, the number of the first data tables is N, the N first data tables are associated with N state of health (SOH), and N is an integer greater than 1;

the determining a first current frequency based on the first temperature, the first state of charge, and one or more preset first data tables includes:

acquiring a first state of health of the battery;
determining a second data table associated with the first state of health from the N first data tables;
determining the first current frequency based on the first temperature, the first state of charge, and the second data table.

The SOH of the battery can be understood as the percentage of the current capacity to the factory capacity of the battery. The same battery may have different charge transfer impedances $R_{ct}$ under different SOH states. Based on the analysis of the condition of the lithium precipitation of the lithium-ion battery mentioned above, it can be concluded that when $R_{ct}$ changes, the current amplitude and frequency that can be used for safe heating of the lithium-ion battery will also change accordingly.

Therefore, in the embodiments, corresponding first data tables can be established for N SOHs. The establishment method of the first data tables will not be detailed here.

The first state of health of the battery can be understood as the current SOH of the battery, and in some examples, the first state of health of the battery can be acquired through BMS.

Due to the association between SOH and the first data tables, when the first state of health is acquired, the second data table associated with the first state of health can be determined from the N first data tables.

From another perspective, the second data table refers to the first data table associated with the first state of health among the N first data tables. Therefore, the second data table can also include the correspondence between the first temperature, the first state of charge, and the first current frequency under the condition of the first current amplitude.

In the embodiments, the first current frequency is determined based on the first temperature, the first state of charge, and the second data table. The first current frequency may correspond to the heating parameters of the battery mentioned above, and the specific purpose will not be repeated here.

When the SOH of the battery is reduced, the impedance of the battery will be increased. In the embodiments, considering the SOH as safety redundancy can further improve the reliability of the battery heating process.

Optionally, the heating the battery based on the first current amplitude and the first current frequency includes:

heating, starting from a first time instance, the battery based on the first current amplitude and the first current frequency;

after the heating the battery based on the first current amplitude and the first current frequency, the method further includes:

returning, under a condition that a second time instance is reached, to perform the step of acquiring a first temperature and a first state of charge of a battery, a period between the second time instance and the first time instance being equal to a first preset period.

In the embodiments, it may be considered that the battery is heated in different heating cycles.

For example, in one heating cycle, the above steps 501 to 503 may be performed and the battery is heated for the first preset period. The first preset period may be preset, and the specific value may not be limited here.

After the battery is heated for the first preset period, it may proceed to the next heating cycle where the steps 501 to 503 are repeated and the battery is heated for the first preset period again.

As shown in Figure 6, it is an example diagram of a battery heating process in the embodiments. In this example diagram, the horizontal axis represents time and the vertical axis represents battery temperature.

Figure 6 shows the periods of three heating cycles on the time axis. The three heating cycles are denoted as heating cycle A, heating cycle B, and heating cycle C respectively. The first current frequency used in respective heating cycle is a first frequency, a second frequency, and a third frequency respectively.

After each heating cycle, the first temperature of the battery will change. Therefore, the first current frequency determined based on the first temperature and the first data table usually also changes accordingly, that is, the first frequency, the second frequency, and the third frequency may usually be unequal.

Generally, the first data tables are established based on the consideration of safe heating and maximum heating efficiency for the battery. In the embodiments, the battery is heated in different heating cycles. In each heating cycle, the current frequency used to heat the battery is adjusted according to the first temperature of the battery, which helps to effectively improve the heating safety and efficiency of the battery.

In some examples, when the first temperature of the battery is greater than a temperature threshold, or when the number of heating cycles reaches a preset number, the heating of the battery can be ended.

In some examples, the waveform of the current for heating the battery may be one of a pulse wave, a square wave, a triangular wave, a single-frequency sine wave, or a combination of multiple-frequency sine waves. That is to say, in practical applications, there may be differences in the waveform types of the current for heating the battery.

Generally, the first current frequency is acquired by querying the first data table, which is often established based on a current condition of a certain waveform type.

For example, when establishing the first data table, the used waveform type of the current may be a single-frequency sine wave. For simplification, the waveform type of the current used when establishing the first data table may be referred to as a reference waveform.

However, in practical applications, the waveform type of the current used for heating the battery may be a pulse wave or a triangular wave. The impact of these waveform types on lithium precipitation of the battery is often difficult to determine. To ensure the safety of the heating process, in the case of determining the first current frequency based on the first data table, the first current frequency may be adjusted according to the waveform type of the current used for heating the battery to obtain a second current frequency.

The adjustment rules for the first current frequency may be set as needed. For example, if the waveform type of the current used for heating the battery is the reference waveform mentioned above, the first current frequency may be directly used as the second current frequency; if the waveform type of the current used for heating the battery is not the reference waveform, the first current frequency may be added with a preset frequency, or multiplied by a preset coefficient to obtain the second current frequency.

For example, in the adjustment rules, each waveform type may correspond to a preset frequency adjustment value or adjustment coefficient. When the waveform type of the current used for heating the battery is acquired, the first current frequency may be added with the frequency adjustment value corresponding to the waveform type, or multiplied by the adjustment coefficient corresponding to the waveform type to obtain the second current frequency.

In the embodiments, the first current frequency determined based on the first data table may be adjusted according to the waveform type of the current for heating the battery to obtain the second current frequency, and the battery may be heated based on the first current amplitude and the second current frequency, which helps to improve the safety of the battery heating process.

According to some embodiments of the present disclosure, after the determining a first current frequency based on the first temperature, the first state of charge, and one or more preset first data tables, the method further includes:

determining, under a condition that a second current amplitude is acquired, a third current frequency based on the second current amplitude, the third current frequency being a safe current frequency for heating the battery under a condition of the second current amplitude;

heating the battery based on the second current amplitude and a larger one of the first current frequency and the third current frequency.

Based on the above embodiments, the first current amplitude may be determined based on the maximum allowable current of the discharge device, and to some extent, the first current amplitude may be considered as an empirical value. In practical applications, different discharge devices may have different maximum allowable currents.

The second current amplitude here may be the maximum allowable current of the discharge device used in practical applications, or a current amplitude determined based on the maximum allowable current of the discharge device used in practical applications.

According to formulas (2) and (4), it can be seen that when the amplitude of the alternating current increases, in order to avoid the lithium precipitation and ensure the safety of battery heating, the current frequency needs to be correspondingly increased.

In the case where the second current amplitude is acquired, a safe current frequency may actually be determined according to formulas (2) and (4), that is, the third current frequency mentioned above. If the current frequency used to heat the battery is lower than the third current frequency, a safety issue may be occurred in the heating process.

Therefore, in the embodiments, the battery may be heated based on the larger one of the first current frequency and the third current frequency as well as the second current amplitude. In this way, the safety of the battery heating process can be effectively guaranteed under conditions of various current amplitude.

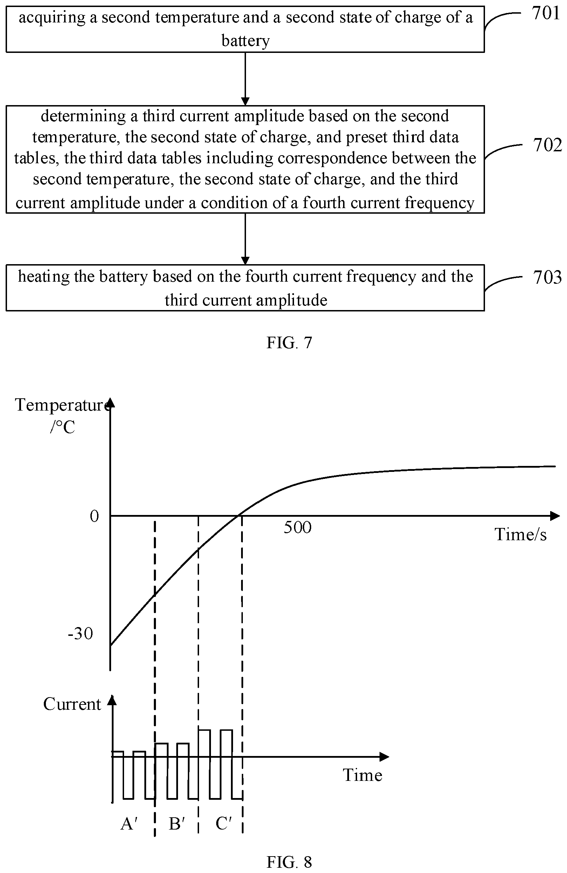

As shown in Figure 7, the embodiments of the present disclosure also provide a battery heating method, including:

step 701, acquiring a second temperature and a second state of charge of a battery;
step 702, determining a third current amplitude based on the second temperature, the second state of charge, and one or more preset third data tables, the third data tables including correspondence between the second temperature, the second state of charge, and the third current amplitude under a condition of a fourth current frequency;

step 703, heating the battery based on the fourth current frequency and the third current amplitude.

In the embodiments, the battery may be a lithium-ion battery, a lithium-sulfur battery, a sodium ion battery, or a magnesium ion battery, etc., which is not limited here. For simplification, the following will mainly take a lithium-ion battery as an example for description.

The second temperature of the battery may refer to a battery temperature collected in real-time, which may be collected through a relevant temperature sensing device. The second temperature may be the temperature inside a battery pack where the battery is located or the temperature of the working environment where the battery is located.

The second state of charge may be the real-time SOC of the battery, which may be collected through a battery SOC signal acquisition device.

In some application scenarios, the second temperature and second state of charge may be collected through a BMS, etc.

The third data tables may be pre-established. During establishing of the third data tables, the current frequency may be controlled, the battery temperature and SOC may be changed, and the EIS data of the battery under each combination of battery temperature and battery SOC may be acquired. Based on the EIS data, the current amplitude under any combination of battery temperature and battery SOC may be determined. Generally, this current amplitude may ensure that under the corresponding combination of battery temperature and battery SOC, the battery will not exhibit polarization phenomenon, and meanwhile be heated internally with a higher heating power.

In other words, when establishing the third data tables, the current frequency may be taken as a fixed value, the battery temperature and battery SOC may be taken as independent variables, and the current amplitude may be measured as the dependent variable.

The current frequency in the third data tables is specifically controlled at the fourth current frequency.

The third data tables may include the correspondence between the second temperature, the second state of charge, and third current amplitude under the condition of the fourth current frequency. After acquiring the second temperature and the second state of charge, the third current amplitude may be determined through the third data tables.

Under a condition that the third current amplitude is determined, the battery may be heated based on the third current amplitude and the fourth current frequency.

The fourth current frequency and the third current amplitude may be target heating parameters or reference heating parameters. For example, in practical applications, the battery may be heated with the fourth current frequency and the third current amplitude, or with the third current amplitude and a current frequency higher than the fourth current frequency.

With the battery heating method provided in the embodiments of the disclosure, the second temperature and the second state of charge of the battery are acquired, the third current amplitude is determined based on the second temperature, the second state of charge, and the preset third data tables, and the battery is heated based on the fourth current frequency and the third current amplitude. The third data tables include correspondence between the second temperature, the second state of charge, and the third current amplitude under the condition of the fourth current frequency. With the embodiments of the disclosure, the current frequency and amplitude used for internal heating can be determined based on the temperature of the battery, so that the heating rate of the battery at various temperature environments is improved.

Secondly, in the embodiments of the present disclosure, since the fourth current frequency is predetermined, the consumption of computing resources caused by determination of the fourth current frequency can be saved in determination of the battery's heating parameters, so that the efficiency of determination of the battery's heating parameters can be improved. Moreover, there is no need to establish the above third data tables for various current amplitudes, which helps to reduce the human and material consumption caused by establishment of the third data tables.

In addition, by determining the first current frequency, the situation that the current frequency actually used for heating the battery is too high due to the lack of the limit of the current frequency used for heating the battery can be avoided.

Meanwhile, in the embodiments of the disclosure, the third data tables are established under the condition of the fourth current frequency, and there is no need to establish correspondence between the battery temperature, the battery SOC, and the current amplitude for multiple current frequencies, which also helps to reduce the human and material resources required for establishing the correspondence.

According to some embodiments of the present disclosure, after the determining a third current amplitude, the method further includes:

acquiring an output voltage of the battery;
heating, under a condition that the output voltage is less than a voltage threshold, the battery based on a preset fifth current frequency and the third current amplitude;
the heating the battery based on the fourth current frequency and the third current amplitude includes:

heating the battery based on the fourth current frequency and the third current amplitude under a condition that the output voltage is greater than or equal to the voltage threshold;

wherein the fifth current frequency is greater than the fourth current frequency.

In practical applications, the battery may provide power to a user device while being heated by the discharge device. Therefore, there is an output voltage for the battery, which may be acquired through a voltage sensing device, etc.

In an application example, the fourth current frequency mentioned above may be a predetermined small frequency value. During the internal heating of the battery, if the output voltage of the battery is low and discharge continues, it may cause the battery to drop below a safe voltage.

The voltage threshold may be considered as a threshold used to determine whether the battery is within a safe voltage range.

When the output voltage of the battery is less than the voltage threshold, it may be considered that the battery is not within the safe voltage range, and continuing discharging may cause the battery to drop below the safe voltage.

In the embodiments, when the output voltage of the battery is less than the voltage threshold, a relatively large fifth current frequency may be used to internally heat the battery.

Based on formula (2), it can be seen that as the current frequency increases, the impedance of the battery will decrease, which helps to ensure that the battery can be reliably within the safe voltage range while discharging, improving the safety of the internal heating process of the battery.

The fifth current frequency may be set as needed. It may be an empirical value or acquired by calibration during the charging and discharging of the battery, which will not be detailed here.

When the output voltage of the battery is greater than or equal to the voltage threshold, it may be considered to some extent that there is no situation where the output voltage of the battery decreases below the safe voltage range during discharge. In this case, the battery may be heated based on a relatively low fourth current frequency and the third current amplitude to ensure the heating efficiency of the battery.

In an embodiment, when the output voltage is less than the voltage threshold, after the battery is heated based on the preset fifth current frequency and the third current amplitude, when the second temperature of the battery rises to a preset temperature value, the battery may be heated based on the fourth current frequency and the third current amplitude.

According to some embodiments of the present disclosure, the third current amplitude is a forward current amplitude;

the heating the battery based on the fourth current frequency and the third current amplitude includes:

heating the battery based on the fourth current frequency, the third current amplitude, and a preset first negative current amplitude.

Generally, the forward current may refer to the current when the battery is in a charging state, while the negative current may refer to the current when the battery is in a discharging state.

When heating the battery internally, the safety issues such as lithium precipitation are often caused by the aforementioned forward current. Therefore, in the embodiments, the third current amplitude that needs to be determined may be the forward current amplitude. Heating the battery based on the third current amplitude and the fourth current frequency should avoid safety issues.

Correspondingly, the negative current has a relatively small impact on the safety issue due to lithium precipitation of the battery. Therefore, its amplitude may be determined as a preset value, that is, the first negative current amplitude mentioned above.

For example, in an example, the first negative current amplitude may be the maximum allowable current amplitude of an electrical device which has been determined during the design of the electrical device. Of course, in other examples, the first negative current amplitude may also be an empirical value.

In the embodiments, the third current amplitude determined based on the third data tables is specifically the forward current amplitude. Heating the battery based on the fourth current frequency, the third current amplitude, and the preset first negative current amplitude helps to improve heating efficiency, while also ensure the safety of the battery heating process and reduce the requirements for amplitude of frequency conversion of the heating device.

According to some embodiments of the present disclosure, after the determining a third current amplitude, the method further includes:

acquiring an output voltage of the battery;

heating, under a condition that the output voltage is less than a voltage threshold, the battery based on the fourth current frequency, the third current amplitude, and a preset second negative current amplitude;

the heating the battery based on the fourth current frequency, the third current amplitude, and a preset first negative current amplitude includes:

heating, under a condition that the output voltage is greater than or equal to the voltage threshold, the battery based on the fourth current frequency, the third current amplitude, and the preset first negative current amplitude; wherein the first negative current amplitude is greater than the second negative current amplitude.

Based on the above embodiments, it can be seen that during the internal heating of the battery, if the output voltage of the battery is low and discharge continues, it may cause the battery to drop below the safe voltage.

Whether the output voltage of the battery is low may be determined based on the comparison between the output voltage and the voltage threshold.

When the output voltage of the battery is greater than or equal to the voltage threshold, it may be considered to some extent that there is no situation where the output voltage of the battery decreases below the safe voltage range during discharge. In this case, the battery may be heated based on the fourth current frequency, the third current amplitude, and the preset first negative current amplitude, ensuring both the heating efficiency of the battery and the normal use of the electrical device.

When the output voltage of the battery is less than the voltage threshold, it is necessary to control the amplitude of the output current, that is, to reduce the amplitude of the negative current.

Specifically, when the output voltage is less than the voltage threshold, the battery is heated based on the fourth current frequency, third current amplitude, and the preset second negative current amplitude. The second negative current amplitude is smaller than the first negative current amplitude to avoid safety issues due to excessive discharge of the battery, thereby helping to improve the battery's service life.

According to some embodiments of the present disclosure, a number of the third data tables is M, the M third data tables are associated with M states of health of the battery, and M is an integer greater than 1;

the determining a third current amplitude based on the second temperature, the second state of charge, and one or more preset third data tables includes:

acquiring a second state of health of the battery;

determining a fourth data table associated with the second state of health from the M third data tables;

determining the third current amplitude based on the second temperature, the second state of charge, and the fourth data table.

Based on the above embodiments, the same battery may have different charge transfer impedances $R_{ct}$ under different SOH states. Based on the analysis of the lithium precipitation condition of lithium-ion batteries mentioned above, it can be concluded that when $R_{ct}$ changes, the amplitude and frequency of the current that can be used for safe heating of the lithium-ion battery will also change accordingly.

In the embodiments, corresponding third data tables may be established for the M SOH. The establishment method of the third data tables will not be detailed here.

The second state of health of the battery may be understood as the current SOH of the battery. In some examples, the second state of health of the battery may be acquired through BMS.

Due to the association between SOH and the third data tables, when the second state of health is acquired, the fourth data table associated with the second state of health may be determined from the M third data tables.

From another perspective, the fourth data table refers to a third data table associated with the second state of health among the N third data tables. Therefore, the fourth data table may also include the correspondence between the second temperature, the second state of charge, and the third current amplitude under the condition of the fourth current frequency.

In the embodiments, the third current amplitude is determined based on the second temperature, the second state of charge, and the fourth data table. The third current amplitude may correspond to the above heating parameters of the battery, and the specific purpose will not be detailed here.

When the battery SOH is reduced, the impedance of the battery will be increased. In the embodiments, considering SOH as safety redundancy may further improve the reliability of the battery heating process.

According to some embodiments of the present disclosure, the heating the battery based on the fourth current frequency and the third current amplitude includes:

heating, starting from a third time instance, the battery based on the fourth current frequency and the third current amplitude;

after the heating the battery based on the fourth current frequency and the third current amplitude, the method further includes:

returning, under a condition that a fourth time instance is reached, to perform the step of acquiring a second temperature and a second state of charge of a battery, a period between the fourth time instance and the third time instance being equal to a second preset period.

In the embodiments, it may be considered that the battery is heated in different heating cycles.

For example, in one heating cycle, the above steps 701 to 703 may be performed and the battery is heated for the second preset period. The second preset period may be preset, and the specific value may not be limited here.

After the battery is heated for the second preset period, it may proceed to the next heating cycle where the steps 701 to 703 are repeated and the battery is heated for the second preset period again.

As shown in Figure 8, it is another example diagram of a battery heating process in the embodiments. In the upper coordinate system of the example diagram, the horizontal axis represents time and the vertical axis represents battery temperature.

Figure 8 shows the periods of three heating cycles on the time axis. The three heating cycles are denoted as heating cycle A', heating cycle B', and heating cycle C' respectively. The current frequency used in each heating cycle may be equal, but the current amplitude may be constantly changing.

In an example, the lower coordinate system in Figure 8 is referred to. In the coordinate system, the horizontal axis represents time and the vertical axis represents current amplitude. It can be seen that the current frequency keeps unchanged. During the heating periods A', B', and C', the forward current amplitude may continuously increase, while the negative current amplitude may keep unchanged.

Of course, in other examples, as the heating cycle proceeds, the negative current amplitude may also be adjusted.

Generally, the third data tables are established based on the consideration of safe heating and maximum heating efficiency for the battery. In the embodiments, the battery is heated in different heating cycles. In each heating cycle, the current amplitude used to heat the battery is adjusted according to the second temperature of the battery, which helps to effectively improve the heating safety and efficiency of the battery.

In the example shown in Figure 8, the waveform of the current used for heating the battery is a square wave. In practical applications, the waveform of the current for heating the battery may be at least one of a pulse wave, a square wave, a triangular wave, a single-frequency sine wave, or a combination of multiple-frequency sine waves.

Of course, in some embodiments, in order to further improve the safety of the battery heating process, the third current amplitude may also be adjusted based on the waveform type, and the battery may be heated based on the fourth current frequency and the adjusted third current amplitude.

For example, when establishing the third data tables, the current waveform used is a single-frequency sine wave, which may be referred to as the reference waveform. The adjustment rules may include the determined third current amplitude being subtracted with a preset current amplitude or multiplied by a positive coefficient less than 1 when the waveform used for heating the battery is not the reference waveform.

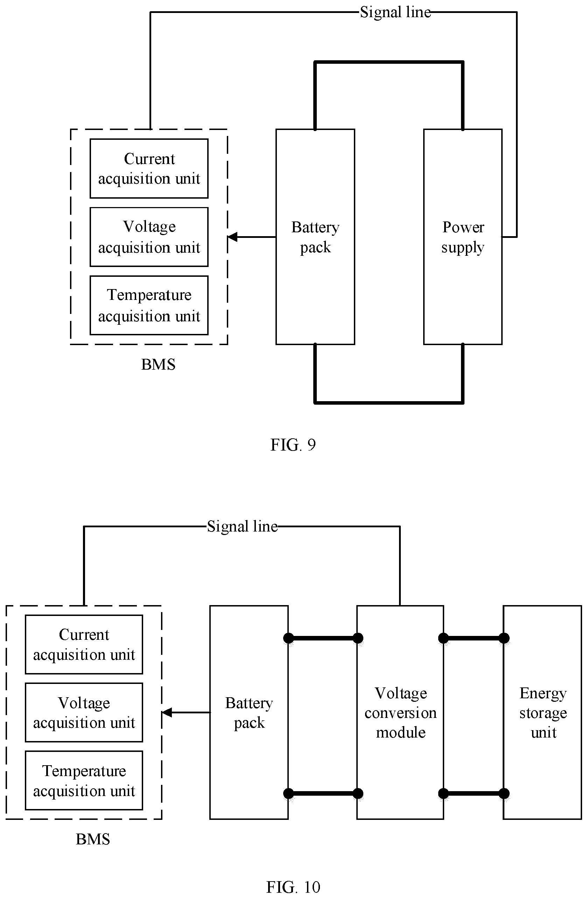

According to some embodiments of the present disclosure, as shown in Figure 9, it is a structural schematic diagram of a heating system for heating a battery. The heating system may include a battery pack and a power supply.

The battery pack may include a battery and a BMS. The BMS includes various types of sensing units, such as a current acquisition unit, a voltage acquisition unit, and a temperature acquisition unit. Of course, the BMS may also include an SOC signal acquisition device, an SOH signal acquisition device, and so on.

In an example where the battery pack is applied in the electric vehicle, the power supply may be a charging station or a motor controller.

In practical applications, the BMS may collect data such as battery temperature and SOC, and generate relevant heating parameters based on these collected data, such as the current frequency and current amplitude mentioned above. Heating parameters may be sent to the power supply through a communication module, such as a signal line, to control the power supply to heat the battery according to the heating parameters.

According to some embodiments of the present disclosure, as shown in Figure 10, it is structural schematic diagram of another heating system for heating a battery. The heating system may include a battery pack, a voltage conversion module, and an energy storage unit.

The functions of the battery pack and the BMS have been described in the previous embodiments and will not be repeated here.

The energy storage unit may be a wind power storage unit or a solar energy storage unit, etc. Alternatively, when the battery pack is used in the electric vehicle, the energy storage unit may also be various electronic components used for energy storage in the electric vehicle.

The voltage conversion module may be used to convert the voltage output by the energy storage unit. The BMS may communicate and connect with the voltage conversion module, and control the operation of the voltage conversion module based on the determined heating parameters.

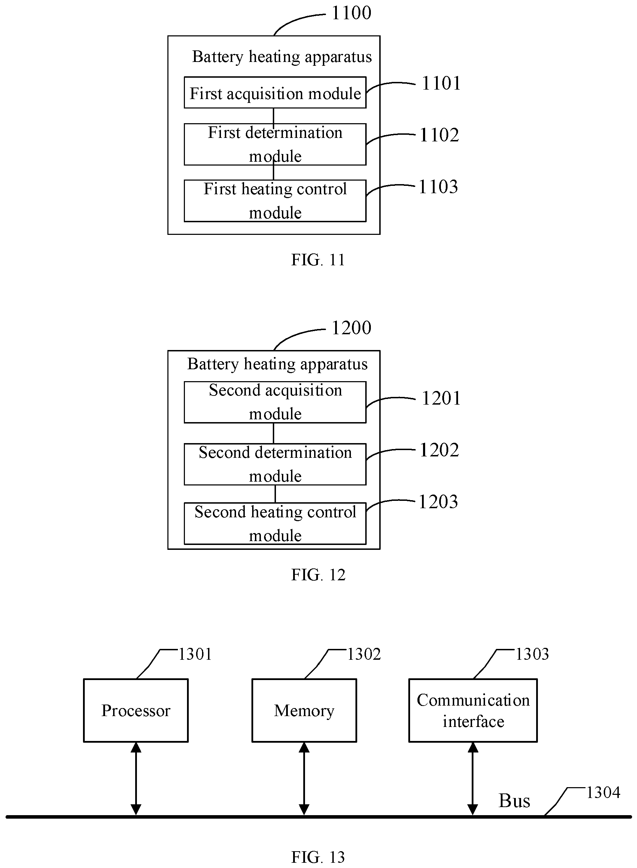

As shown in Figure 11, the embodiments of the present disclosure also provide a battery heating apparatus 1100 including:

a first acquisition module 1101, configured to acquire a first temperature and a first state of charge of a battery;
a first determination module 1102, configured to determine a first current frequency based on the first temperature, the first state of charge, and one or more preset first data tables, the first data tables including correspondence between the first temperature, the first state of charge, and the first current frequency under a condition of a first current amplitude;

a first heating control module 1103, configured to heat the battery based on the first current amplitude and the first current frequency.

According to some embodiments of the present disclosure, a number of the first data tables is N, the N first data tables are associated with N states of health of the battery, and N is an integer greater than 1;

the first determination module 1102 includes:

a first acquisition unit, configured to acquire a first state of health of the battery;
a first determination unit, configured to determine a second data table associated with the first state of health from the N first data tables;
a second determination unit, configured to determine the first current frequency based on the first temperature, the first state of charge, and the second data table.

According to some embodiments of the present disclosure, the first heating control module 1103 includes:

a first heating control unit, configured to heat, starting from a first time instance, the battery based on the first current amplitude and the first current frequency;
correspondingly, the battery heating apparatus 1100 further includes:
a first execution module, configure to return, under a condition that a second time instance is reached, to perform the acquiring a first temperature and a first state of charge of a battery, a period between the second time instance and the first time instance being equal to a first preset period.

According to some embodiments of the present disclosure, the battery heating apparatus 1100 further includes:

a third acquisition module, configured to determine, under a condition that a second current amplitude is acquired, a third current frequency based on the second current amplitude, the third current frequency being a safe current frequency for heating the battery under a condition of the second current amplitude;
a third heating control module, configured to heat the battery based on the second current amplitude and a larger one of the first current frequency and the third current frequency.

As shown in Figure 12, the embodiments of the present disclosure also provide a battery heating apparatus 1200 including:

a second acquisition module 1201, configured to acquire a second temperature and a second state of charge of a battery;
a second determination module 1202, configured to determine a third current amplitude based on the second temperature, the second state of charge, and one or more preset third data tables, the third data tables including correspondence between the second temperature, the second state of charge, and the third current amplitude under a condition of a fourth current frequency;
a second heating control module 1203, configured to heat the battery based on the fourth current frequency and the third current amplitude.

According to some embodiments of the present disclosure, the battery heating apparatus 1200 further includes:

a fourth acquisition module, configured to acquire an output voltage of the battery;
a fourth heating control module, configured to heat, under a condition that the output voltage is less than a voltage threshold, the battery based on a preset fifth current frequency and the third current amplitude;
correspondingly, the second heating control module 1203 may be configured to heat the battery based on the fourth current frequency and the third current amplitude under a condition that the output voltage is greater than or equal to the voltage threshold;
wherein the fifth current frequency is greater than the fourth current frequency.

According to some embodiments of the present disclosure, the third current amplitude is a forward current amplitude;

correspondingly, the second heating control module 1203 includes:

a second heating control unit, configured to heat the battery based on the fourth current frequency, the third current amplitude, and a preset first negative current amplitude.

According to some embodiments of the present disclosure, the battery heating apparatus 1200 may further include:

a fifth acquisition module, configured to acquire an output voltage of the battery;

a fifth heating control module, configured to heat, under a condition that the output voltage is less than a voltage threshold, the battery based on the fourth current frequency, the third current amplitude, and a preset second negative current amplitude;

correspondingly, the second heating control module 1203 is configured to heat, under a condition that the output voltage is greater than or equal to the voltage threshold, the battery based on the fourth current frequency, the third current amplitude, and the preset first negative current amplitude;

wherein the first negative current amplitude is greater than the second negative current amplitude.

According to some embodiments of the present disclosure, a number of the third data tables is M, the M third data tables are associated with M states of health of the battery, and M is an integer greater than 1;

According to some embodiments of the present disclosure, the second determination module 1202 includes:

a second acquisition unit, configured to acquire a second state of health of the battery;

a third determination unit, configured to determine a fourth data table associated with the second state of health from the M third data tables;

a fourth determination unit, configured to determine the third current amplitude based on the second temperature, the second state of charge, and the fourth data table.

According to some embodiments of the present disclosure, the second heating control module 1203 includes:

a third heating control unit, configured to heat, starting from a third time instance, the battery based on the fourth current frequency and the third current amplitude;

correspondingly, the battery heating apparatus 1200 may further include:

a second execution module, configured to return, under a condition that a fourth time instance is reached, to perform the acquiring a second temperature and a second state of charge of a battery, a period between the fourth time instance and the third time instance being equal to a second preset period.

It should be noted that the battery heating apparatus is an apparatus corresponding to the above-mentioned battery heating method, and all the implementation in the embodiments of the above-mentioned method are applicable to the embodiments of the apparatus, and can achieve the same technical effect.

Figure 13 illustrates a schematic diagram of a hardware structure of an electronic device disclosed in an embodiment of the present disclosure.

The electronic device may include a processor 1301 and a memory 1302 storing computer program instructions.

Specifically, the above processor 1301 may include a Central Processing Unit (CPU), or an Application Specific Integrated Circuit (ASIC), or may be configured to be one or more integrated circuits implementing the embodiments of the present disclosure.

The memory 1302 may include a large-capacity memory for data or instructions. For example rather limitation, the memory 1302 may include a Hard Disk Drive (HDD), a floppy disk drive, a flash memory, an optical disk, a magneto-optical disk, a magnetic tape, or a Universal Serial Bus (USB) drive, or a combination of two or more thereof. Appropriately, the memory 1302 may include removable or non-removable (or fixed) media. Appropriately, the memory 602 may be inside or outside of the battery heating device. In some embodiments, the memory 1302 is a non-volatile solid-state memory.

The memory may include a read-only memory (ROM), a random access memory (RAM), a magnetic disk storage media device, an optical storage media device, a flash memory device, an electrical, optical, or other physical/tangible memory storage device. Therefore, generally, the memory includes one or more tangible (non-transitory) computer-readable storage media (e.g., memory devices) encoded with software including computer-executable instructions, and when the software is executed (e.g., by one or more processors), it is operable to perform the operations described with reference to the methods according to the present disclosure.

The processor 1301 implements any of the battery heating methods in the above embodiments by reading and executing the computer program instructions stored in the memory 1302.

In an example, the electronic device may further include a communication interface 1303 and a bus 1304. As shown in Fig. 13, the processor 1301, the memory 1302, and the communication interface 1303 are connected and complete mutual communication through the bus 1304.

The communication interface 1303 is mainly used to implement communication between various modules, means, units and/or devices in the embodiments of the present disclosure.

The bus 1304 includes hardware, software, or both. For example rather limitation, the bus may include Accelerated Graphics Port (AGP) or other graphics bus, Extended Industry Standard Architecture (EISA) bus, Front Side Bus (FSB), Hyper Transport (HT) interconnection, Industry Standard Architecture (ISA) bus, unlimited bandwidth interconnection, Low Pin Count (LPC) bus, memory bus, microchannel architecture (MCA) bus, Peripheral Component Interconnection (PCI) bus, PCI-Express (PCI-X) bus, Serial Advanced Technology Attachment (SATA) bus, Video Electronics Standards Association Local (VLB) bus or other suitable bus, or a combination of two or more thereof. Appropriately, the bus 1304 may include one or more buses. Although the embodiments of the present disclosure describe and show a specific bus, any suitable bus or interconnection is contemplated in the present disclosure.

In addition, in combination with the battery heating methods in the above embodiments, the embodiments of the present disclosure may provide a computer storage medium for implementation. The computer storage medium stores computer program instructions which, when executed by the processor, implement any of the battery heating methods in the above embodiments.

It should be clear that the present disclosure is not limited to the specific configuration and process described above and shown in the drawings. For the sake of brevity, a detailed description of known method is omitted here. In the above embodiments, several specific steps are described and shown as examples. However, the method process of the present disclosure is not limited to the specific steps described and shown, and those skilled in the art may make various changes, modifications and additions, or change the order between the steps after understanding the spirit of the present disclosure.

The function modules in the above structural diagrams may be implemented as hardware, software, firmware, or a combination thereof. When implemented in hardware, it may be, for example, an electronic circuit, an Application Specific Integrated Circuit (ASIC), appropriate firmware, a plug-in device, a function card, and the like. When implemented in software, the elements of the present disclosure may be program(s) or code segment(s) that is configured to perform the required tasks. The program(s) or code segment(s) may be stored in a machine-readable medium, or transmitted on a transmission medium or a communication link through a data signal carried on a carrier wave. A "machine-readable medium" may include any medium capable of storing or transmitting information. Examples of machine-readable media include electronic circuits, semiconductor memory devices, ROM, flash memory, erasable ROM (EROM), floppy disks, CD-ROMs, optical disks, hard disks, optical fiber media, radio frequency (RF) links, etc. Code segments may be downloaded via a computer network such as the Internet, an intranet, and the like.

It should also be noted that the exemplary embodiments mentioned in the present disclosure describe some methods or systems based on a series of steps or devices. However, the present disclosure is not limited to the order of the above steps, that is, the steps may be performed in the order mentioned in the embodiments, or may be performed in a different order from that of the embodiments, or several steps may be performed at the same time.

Various aspects of the present disclosure have been described above with reference to the flowcharts and/or block diagrams of the methods, apparatuses (systems), and computer program products according to the embodiments of the present disclosure. It should be understood that each block in the flowcharts and/or block diagrams and combinations of blocks in the flowcharts and/or block diagrams can be implemented by computer program instructions. These computer program instructions can be provided to a processor of a general-purpose computer, a special-purpose computer, or other programmable data processing device to produce a machine, so that the execution of these instructions via the processor of the computer or other programmable data processing device enables implementation of the functions/actions specified in one or more blocks of the flowcharts and/or block diagrams. Such a processor can be, but is not limited to, a general-purpose processor, a dedicated processor, a special application processor, or a field programmable logic circuit. It can also be understood that each block in the block diagrams and/or flowcharts and the combination of the blocks of the block diagrams and/or flowcharts can also be implemented by dedicated hardware that performs the specified function or action, or can be implemented by a combination of dedicated hardware and computer instructions.

The above descriptions are only specific implementations of the present disclosure. Those skilled in the art can clearly understand that for convenience and conciseness of description, the specific operation process of the above-described systems, modules and units may refer to the corresponding process in the forgoing method embodiments, which will not be repeated here. It should be understood that the protection scope of the present disclosure is not limited to the embodiments, and any person skilled in the art can easily conceive various equivalent modifications or substitutions within the technical scope disclosed in the present disclosure, and these modifications or substitutions should be within the protection scope of the present disclosure.

**Claims**

1. A battery heating method, comprising:

   acquiring a first temperature and a first state of charge of a battery;
   determining a first current frequency based on the first temperature, the first state of charge, and one or more preset first data tables, the first data tables including correspondence between the first temperature, the first state of charge, and the first current frequency under a condition of a first current amplitude;
   heating the battery based on the first current amplitude and the first current frequency.

2. The method according to claim 1, wherein a number of the first data tables is N, the N first data tables are associated with N states of health of the battery, and N is an integer greater than 1;
   the determining a first current frequency based on the first temperature, the first state of charge, and one or more preset first data tables comprises:

   acquiring a first state of health of the battery;
   determining a second data table associated with the first state of health from the N first data tables;
   determining the first current frequency based on the first temperature, the first state of charge, and the second data table.

3. The method according to claim 1, wherein the heating the battery based on the first current amplitude and the first current frequency comprises:

   heating, starting from a first time instance, the battery based on the first current amplitude and the first current frequency;
   after the heating the battery based on the first current amplitude and the first current frequency, the method further comprises:
   returning, under a condition that a second time instance is reached, to perform the acquiring a first temperature and a first state of charge of a battery, a period between the second time instance and the first time instance being equal to a first preset period.

4. The method according to claim 1, wherein after the determining a first current frequency based on the first temperature, the first state of charge, and one or more preset first data tables, the method further comprises:

   determining, under a condition that a second current amplitude is acquired, a third current frequency based on the second current amplitude, the third current frequency being a safe current frequency for heating the battery under a condition of the second current amplitude;
   heating the battery based on the second current amplitude and a larger one of the first current frequency and the third current frequency.

5. A battery heating method, comprising:

   acquiring a second temperature and a second state of charge of a battery;
   determining a third current amplitude based on the second temperature, the second state of charge, and one or more preset third data tables, the third data tables including correspondence between the second temperature, the second state of charge, and the third current amplitude under a condition of a fourth current frequency;
   heating the battery based on the fourth current frequency and the third current amplitude.

6. The method according to claim 5, wherein after the determining a third current amplitude, the method further comprises:

   acquiring an output voltage of the battery;
   heating, under a condition that the output voltage is less than a voltage threshold, the battery based on a preset fifth current frequency and the third current amplitude;
   the heating the battery based on the fourth current frequency and the third current amplitude comprises:

   heating the battery based on the fourth current frequency and the third current amplitude under a condition that the output voltage is greater than or equal to the voltage threshold;

wherein the fifth current frequency is greater than the fourth current frequency.

7. The method according to claim 5, wherein the third current amplitude is a positive current amplitude; the heating the battery based on the fourth current frequency and the third current amplitude comprises: heating the battery based on the fourth current frequency, the third current amplitude, and a preset first negative current amplitude.

8. The method according to claim 7, wherein after the determining a third current amplitude, the method further comprises:

   acquiring an output voltage of the battery;
   heating, under a condition that the output voltage is less than a voltage threshold, the battery based on the fourth current frequency, the third current amplitude, and a preset second negative current amplitude;
   the heating the battery based on the fourth current frequency, the third current amplitude, and a preset first negative current amplitude comprises:

      heating, under a condition that the output voltage is greater than or equal to the voltage threshold, the battery based on the fourth current frequency, the third current amplitude, and the preset first negative current amplitude;
      wherein the first negative current amplitude is greater than the second negative current amplitude.

9. The method according to claim 5, wherein a number of the third data tables is M, the M third data tables are associated with M states of health of the battery, and M is an integer greater than 1; the determining a third current amplitude based on the second temperature, the second state of charge, and one or more preset third data tables comprises:

   acquiring a second state of health of the battery;
   determining a fourth data table associated with the second state of health from the M third data tables;
   determining the third current amplitude based on the second temperature, the second state of charge, and the fourth data table.

10. The method according to claim 5, wherein the heating the battery based on the fourth current frequency and the third current amplitude comprises:

   heating, starting from a third time instance, the battery based on the fourth current frequency and the third current amplitude;
   after the heating the battery based on the fourth current frequency and the third current amplitude, the method further comprises:
   returning, under a condition that a fourth time instance is reached, to perform the acquiring a second temperature and a second state of charge of a battery, a period between the fourth time instance and the third time instance being equal to a second preset period.

11. A battery heating apparatus, comprising:

   a first acquisition module, configured to acquire a first temperature and a first state of charge of a battery;
   a first determination module, configured to determine a first current frequency based on the first temperature, the first state of charge, and one or more preset first data tables, the first data tables including correspondence between the first temperature, the first state of charge, and the first current frequency under a condition of a first current amplitude;
   a first heating control module, configured to heat the battery based on the first current amplitude and the first current frequency.

12. A battery heating apparatus, comprising:

   a second acquisition module, configured to acquire a second temperature and a second state of charge of a battery;
   a second determination module, configured to determine a third current amplitude based on the second temperature, the second state of charge, and one or more preset third data tables, the third data tables including correspondence between the second temperature, the second state of charge, and the third current amplitude under a condition of a fourth current frequency;
a second heating control module, configured to heat the battery based on the fourth current frequency and the third current amplitude.

13. An electronic device, comprising a processor, and a memory storing computer program instructions;
wherein the processor executes the computer program instructions to implement the battery heating method according to any one of claims 1-4, or implement the battery heating method according to any one of claims 5-10.

14. A computer storage medium storing computer program instructions thereon, which, when executed by a processor, implement the battery heating method according to any one of claims 1-4 or implement the battery heating method according to any one of claims 5-10.

Z1                    Z2                    Z3

FIG. 1

Current frequency (Hz)

FIG. 2

FIG. 3

FIG. 4

acquiring a first temperature and a first state of charge of a battery — 501

determining a first current frequency based on the first temperature, the first state of charge, and preset first data tables, the first data tables including correspondence between the first temperature, the first state of charge, and the first current frequency under a condition of a first current amplitude — 502

heating the battery based on the first current amplitude and the first current frequency — 503

FIG. 5

FIG. 6

acquiring a second temperature and a second state of charge of a battery — 701

determining a third current amplitude based on the second temperature, the second state of charge, and preset third data tables, the third data tables including correspondence between the second temperature, the second state of charge, and the third current amplitude under a condition of a fourth current frequency — 702

heating the battery based on the fourth current frequency and the third current amplitude — 703

FIG. 7

FIG. 8

Signal line

Current
acquisition unit

Voltage
acquisition unit

Battery
pack

Power
supply

Temperature
acquisition unit

BMS

FIG. 9

Signal line

Current
acquisition unit

Voltage
acquisition unit

Battery
pack

Voltage
conversion
module

Energy
storage
unit

Temperature
acquisition unit

BMS

FIG. 10

1100

Battery heating apparatus

First acquisition module — 1101

First determination module — 1102

First heating control module — 1103

FIG. 11

1200

Battery heating apparatus

Second acquisition module — 1201

Second determination module — 1202

Second heating control module — 1203

FIG. 12

1301

Processor

1302

Memory

1303

Communication interface

Bus — 1304

FIG. 13

# EP 4 287 350 A1

<div align="center">

## INTERNATIONAL SEARCH REPORT

</div>

| International application No. |
| --- |
| **PCT/CN2021/134746** |

| A. | CLASSIFICATION OF SUBJECT MATTER |
| --- | --- |
| | H01M 10/44(2006.01)i |

According to International Patent Classification (IPC) or to both national classification and IPC

| B. | FIELDS SEARCHED |
| --- | --- |

Minimum documentation searched (classification system followed by classification symbols)

    H01M

Documentation searched other than minimum documentation to the extent that such documents are included in the fields searched

Electronic data base consulted during the international search (name of data base and, where practicable, search terms used)

    CNABS; CNTXT; DWPI; VEN; ENTXT; CNKI: 电池, 加热, 温度, 荷电状态, 电流幅值, 电流频率, 健康度, 电压阈值, battery, heat, temperature, SOC, state of charge, current amplitude, current frequency, SOH, state of health, voltage threshold

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 103825060 A (TSINGHUA UNIVERSITY) 28 May 2014 (2014-05-28) description, paragraphs 2 and 5-72, and figure 2 | 1-14 |
| X | CN 108199122 A (HARBIN INSTITUTE OF TECHNOLOGY) 22 June 2018 (2018-06-22) description, paragraphs 108-242 | 1-14 |
| A | CN 109659637 A (BEIJING JIAOTONG UNIVERSITY) 19 April 2019 (2019-04-19) entire document | 1-14 |
| A | CN 104064836 A (BEIJING JIAOTONG UNIVERSITY) 24 September 2014 (2014-09-24) entire document | 1-14 |
| A | CN 113659245 A (POWERAMP TECHNOLOGY LTD.) 16 November 2021 (2021-11-16) entire document | 1-14 |
| A | CN 112582710 A (SUNWODA ELECTRIC VEHICLE BATTERY CO., LTD.) 30 March 2021 (2021-03-30) entire document | 1-14 |
| A | US 2009235095 A1 (FUJITSU LTD.) 17 September 2009 (2009-09-17) entire document | 1-14 |

☐ Further documents are listed in the continuation of Box C.    ☑ See patent family annex.

| | |
| --- | --- |
| *   Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **31 July 2022** | **10 August 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

28

**INTERNATIONAL SEARCH REPORT**
Information on patent family members

International application No.

**PCT/CN2021/134746**

| Patent document cited in search report | | | Publication date (day/month/year) | Patent family member(s) | | | Publication date (day/month/year) |
|---|---|---|---|---|---|---|---|
| CN | 103825060 | A | 28 May 2014 | CN | 103825060 | B | 29 June 2016 |
| CN | 108199122 | A | 22 June 2018 | CN | 108199122 | B | 13 September 2019 |
| CN | 109659637 | A | 19 April 2019 | CN | 109659637 | B | 15 September 2020 |
| CN | 104064836 | A | 24 September 2014 | CN | 104064836 | B | 06 July 2016 |
| CN | 113659245 | A | 16 November 2021 | None | | | |
| CN | 112582710 | A | 30 March 2021 | None | | | |
| US | 2009235095 | A1 | 17 September 2009 | JP | 2009223955 | A | 01 October 2009 |
| | | | | US | 7933086 | B2 | 26 April 2011 |

Form PCT/ISA/210 (patent family annex) (January 2015)